# EUROPEAN PATENT APPLICATION

(11) **EP 1 974 844 A1**
(43) Date of publication of application: **01.10.2008**
(21) Application number: 06842867.1
(22) Date of filing: 19.12.2006
(51) Int. Cl.: B23K 1/008, B23K 3/04, B23K 31/02

(54) **REFLOW APPARATUS**

(30) Priority: 06.01.2006 JP 2006001782
(71) Applicant: Tamura Corporation, Tokyo 178-8511 (JP); Tamura Fa System Corporation, Sayama-shi Saitama 350-1300 (JP)
(72) Inventor: YAMASHITA, Fumihiro, Saitama 350-1328 (JP); MATSUHISA, Shoichiro, Saitama 350-1328 (JP); KAWAKAMI, Takehiko, Saitama 350-1328 (JP)
(74) Representative: Shindler, Nigel
(86) International application number: PCT/JP2006/325263
(87) International publication number: WO 2007/077727

(57) **Abstract**

The present invention provides a reflow apparatus capable of precisely adjusting the heating temperature and heating time when heating a work for reflow. A work transfer conveyor 12 for transferring a work W into a furnace body 11 is disposed, wherein a plurality of preheating zones 13a through 13e for preheating the work W, a plurality of reflow zones 14a, 14b and 14c for heating the work W for reflow, and a plurality of cooling zones 15a and 15b for cooling the work W are successively arranged along the work transfer conveyor 12 in the furnace body 11. The individual reflow zones 14a, 14b and 14c are formed shorter than the individual preheating zones 13a through 13e in the work transfer direction. It is preferable that the sizes of the individual reflow zones 14a, 14b and 14c in the transfer direction are shortened to approximately 65% to 85% with respect to the individual preheating zones 13a through 13e or the conventional individual reflow zones.

## Description

### Technical Field

The present invention relates to a reflow apparatus used in heating for reflow.

### Background Art

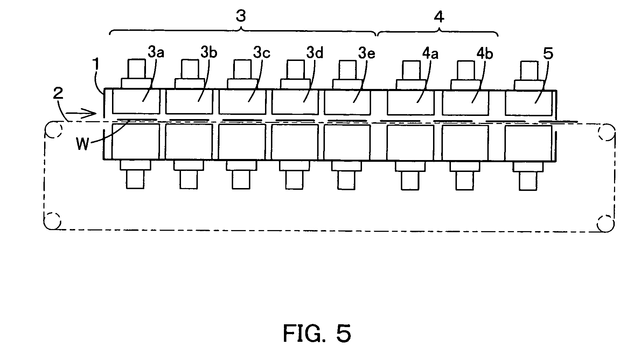

As shown in Fig. 5, a reflow apparatus has a preheating area 3 including a plurality of preheating zones 3a, 3b, 3c, 3d and 3e for preheating a work W, a reflow area 4 including a plurality of reflow zones 4a and 4b for heating the work W for reflow, and a cooling zone 5 for cooling the work W, all of which are successively arranged in a furnace body 1 along a work transfer conveyor 2 for transferring a work W into the furnace body 1.

The lengths of individual preheating zones 3a, 3b, 3c, 3d, and 3e of the preheating area 3 and those of the reflow zones 4a and 4b of the reflow area 4 are formed to be the same in the work transfer direction (For example, refer to Patent Documents 1, 2 and 3).
Patent Document 1: Japanese Laid-Open Patent Publication No. 2001-198671 (Pages 3-4, and Fig. 2)
Patent Document 2: Japanese Laid-Open Patent Publication No. 2003-133718 (Pages 2-3, and Fig. 1)
Patent Document 3: Japanese Laid-Open Patent Publication No. 2005-175288 (Pages 6-7, and Fig. 1)

### Disclosure of the Invention

### Problem to be Solved by the Invention

In recent years, lead-free solder, which does not use any lead, has been used in view of the earth's environment, wherein it is necessary to heat lead-free solder at a higher temperature than lead-contained solder because it has a higher melting point. On the other hand, although it is necessary to more precisely control the heating temperature and heating time in order to secure heat resistance of components to be mounted on a substrate, which are heated for reflow, the control is difficult by conventional reflow apparatuses, wherein particularly there is a problem that it is not easy to precisely adjust the reflow peak time.

The present invention has been made in view of such a point, and it is therefore an object of the present invention to provide a reflow apparatus capable of precisely adjusting a temperature profile such as a reflow peak time when heating a work for reflow.

### Means for Solving the Problem

A reflow apparatus according to Claim 1 of the invention includes a furnace body, a work transfer conveyor for transferring a work into the furnace body, a preheating area having a plurality of preheating zones, which is provided in the furnace body along the work transfer conveyor and preheats the work, and a reflow area having a plurality of reflow zones for heating the work for reflow, which is provided in the furnace body along the work transfer conveyor, wherein the lengths of individual reflow zones of the reflow area are formed shorter than the lengths of individual preheating zones of the preheating area in the work transfer direction.

A reflow apparatus according to Claim 2 of the invention provides three reflow zones in the reflow area in the reflow apparatus according to Claim 1, and is capable of setting a temperature profile of the reflow area based on respective set temperatures.

### Effects of the Invention

According to Claim 1 of the invention, since a plurality of reflow zones that are formed shorter in length than the individual preheating zones of the preheating area in the work transfer direction are provided in the reflow area, it becomes possible to more precisely adjust the temperature profile, such as reflow peak time, etc., of a work that is subjected to heating in these reflow zones for reflow than in the conventional art, wherein components having weak heat resistance can be processed with the reflow peak time shortened by a compact temperature profile, on the other hand, it is possible to secure a reflow peak time necessary and sufficient to obtain a sufficient soldering connection, and various temperature profiles can be set. Further, various temperature profiles can be set without making a conventional apparatus large-sized, wherein a wide range of work characteristics can be processed.

According to Claim 2 of the invention, it becomes possible to further precisely adjust the temperature profile of the reflow area by individually controlling the temperature of three reflow zones, wherein the variation in the temperature adjustment profile can be widened.

### Brief Description of the Drawings

Fig. 1 is a schematic view showing one embodiment of a reflow apparatus according to the present invention;
Fig. 2 is a characteristic view showing the temperature profile of a work heated by the same reflow apparatus;
Fig. 3 is a characteristic view showing the temperature profile of a work heated in the reflow area of the same reflow apparatus, wherein (a) through (g) show temperature profiles of works heated by various heating patterns for reflow in the reflow area according to the present invention, and (h) shows a temperature profile of a work heated by a prior art reflow area;
Fig. 4 is a sectional view of a work to describe a generation mechanism of a chip standing phenomenon; and
Fig. 5 is a brief view showing a conventional reflow apparatus.

### Description of Numerals

- W: Work
- 11: Furnace body
- 12: Work transfer conveyor
- 13: Preheating area
- 13a, 13b, 13c, 13d, 13e: (13a through 13e) Preheating zones
- 14: Reflow area
- 14a, 14b, 14c: Reflow zones

### Best Mode for Carrying Out the Invention

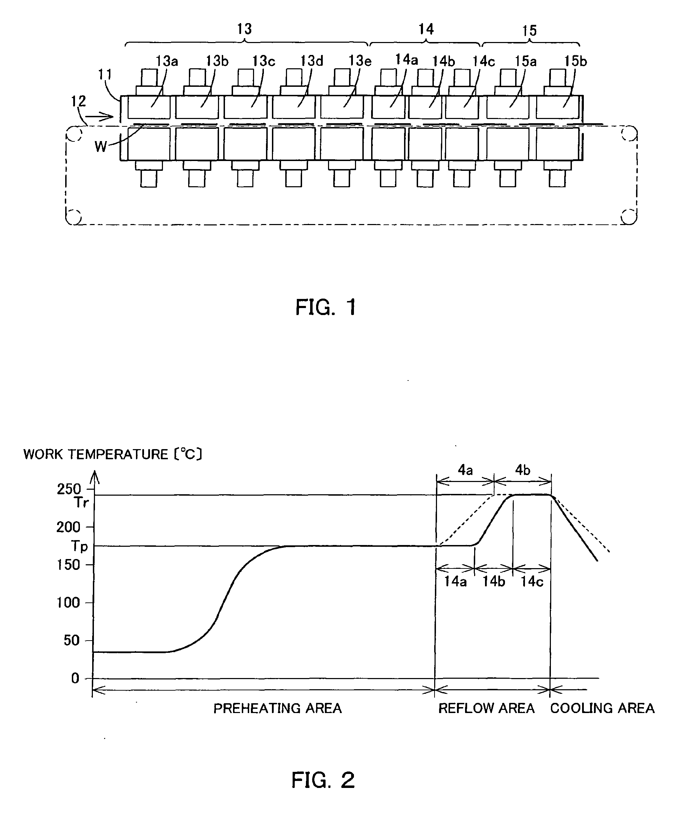

Hereinafter, a detailed description is given of the present invention with reference to one embodiment shown in Fig. 1 through Fig. 3.

Fig. 1 shows a reflow apparatus. Awork transfer conveyor 12 for transferring a work W into the furnace body 11 is disposed. A preheating area 13 having a plurality of preheating zones 13a, 13b, 13c, 13d, and 13e (hereinafter, these reference numerals are described to be 13a through 13e) for preheating a work W, a reflow area 14 having a plurality of reflow zones 14a, 14b and 14c for heating the work W for reflow, and a cooling area 15 having a plurality of cooling zones 15a and 15b for cooling the work W are successively arranged along the work transfer conveyor 12 in the furnace body 11.

A heating unit consisting of a blower and a structure, which circulate the atmospheric air, a heater for heating the atmospheric air, a nozzle for jetting hot air, and a temperature sensor for detecting a hot air temperature is disposed at the respective preheating zones 13a through 13e of the preheating area 13 and the respective reflow zones 14a, 14b and 14c of the reflow area 14 at the upper side and the lower side of the work transfer conveyor 12, respectively, so that the conveyor 12 is placed therebetween, and the temperature of the heating unit is controlled by a process controller.

Here, the zone means an area where the heating temperature of a work W can be individually controlled as in the heating unit, and five preheating zones 13a through 13e are provided in the preheating area 13, three reflow zones 14a, 14b and 14c are provided in the reflow area 14, and two cooling zones 15a and 15b are provided in the cooling area 15, wherein respective temperature profiles of the respective areas 13, 14 and 15 can be established based on respective set temperatures of the respective zones.

The individual reflow zones 14a, 14b and 14c of the reflow area 14 are formed shorter in the work transfer direction than the preheating zones 13a through 13e of the preheating area 13.

In this case, it is preferable that the size of the individual reflow zones 14a, 14b and 14c in the work transfer direction is shortened to approximately 65% to 85% with respect to the sizes of the individual preheating zones 13a through 13e or the conventional individual reflow zones 4a and 4b shown in Fig. 5.

For example, if the entire length of the three reflow zones 14a, 14b and 14c is set to the same as the length of any two of the preheating zones 13a through 13e or the entire length of the conventional two reflow zones 4a and 4b shown in Fig. 5, the reflow area 14 can be prevented from being made large-sized.

Next, a description is given of operations and effects of the embodiment.

A work W is transferred into the furnace body 11 by the work transfer conveyor 12 driven at a fixed speed, the work is heated to a preheating temperature in a plurality of preheating zones 13a through 13e of the preheating area 13 and maintained at the temperature, next, the work W is heated to more than a solder paste melting temperature in a plurality of reflow zones 14a, 14b and 14c of the reflow area 14, the solder paste of the work W is melted and the work W is subjected toreflowsoldering, and finally, the work temperature is lowered by a plurality of cooling zones 15a and 15b of the cooling area 15. After that, the work W is taken out from the furnace body 11 by means of the work transfer conveyor 12 with the strength of the soldering joints secured.

As shown by a solid line in Fig. 2, the work temperature is raised to a fixed preheating temperature Tp in the preheating zones 13a through 13e by the process controller, and at the same time, the preheating temperature Tp is controlled so as to be maintained, and, in the reflow zones 14a, 14b and 14c, the preheating temperature Tp is controlled so as to be maintained in, for example, the first reflow zone 14a, and the temperature is raised from the preheating temperature Tp to the reflow temperature Tr in the intermediate reflow zone 14b, and the reflow temperature Tr is controlled so as to be maintained in the final reflow zone 14c. The work temperature is forcibly lowered in the cooling zones 15a and 15b.

On the other hand, in the conventional reflow apparatus shown in Fig. 5, as shown by dashed lines in Fig. 2, since the work temperature is raised from the preheating temperature Tp to the reflow temperature Tr in the front half reflow zone 4a, and the reflow temperature Tr is controlled in the back half reflow zone 4b so as to be maintained, it is too long for a work W such as a substrate having weak heat resistance components mounted thereon to be exposed to the reflow temperature Tr or its neighboring temperature.

The process controller ideally models respective object blocks, the temperature of which is controlled, of the respective preheating zones 13a through 13e, reflow zones 14a, 14b and 14c and cooling zones 15a and 15b, and controls a temperature adjustment process, whereby temperature stability is improved when successively inputting works W.

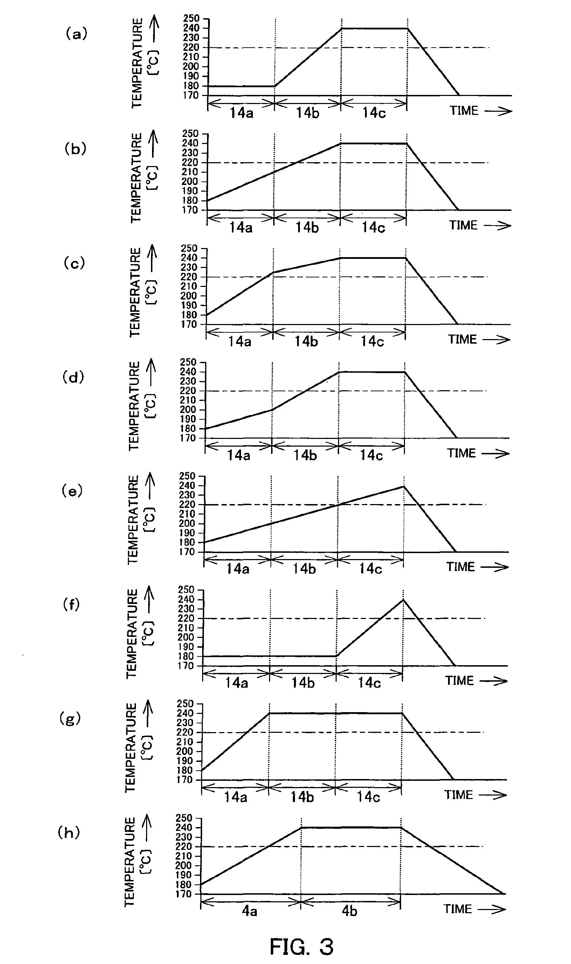

Fig. 3 (a) through (g) show temperature profiles of work W heated in the reflow zones 14a, 14b and 14c according to the present invention, Fig. 3(h) shows a temperature profile of work W heated in the conventional reflow zones 4a and 4b. Sn-Ag-Cu based solder that is the mainstream of lead-free solder is used as a solder paste. The melting temperature of the solder paste is approximately 220°C.

Fig. 3(a) is similar to the temperature profile shown in Fig. 2. The preheating temperature is controlled so as to be maintained at 180°C in the first reflow zone 14a, the preheating temperature is raised from 180°C to the reflow temperature of 240°C in the intermediate reflow zone 14b, and the temperature is controlled so as to be maintained at the reflow temperature of 240°C in the final reflow zone 14c, wherein the heating time for reflow can be easily shortened in comparison with the conventional example (h).

In Fig. 3 (b) , the work temperature is raised at a constant slope from the preheating temperature 180°C to the reflow temperature 240°C in the first reflow zone 14a and the intermediate reflow zone 14b, and the temperature is controlled so as to be maintained at the reflow temperature 240°C in the final reflow zone 14c, whereby the temperature rise slope is made more gradual than in (a) when melting the solder paste, and the heating time for reflow may be set slightly longer in a state where the solder paste is melted.

In Fig. 3(c), the temperature rise slope from the preheating temperature 180°C to a melted state of solder paste is set large in the first reflow zone 14a, the temperature is slowly raised to the reflow temperature 240°C in the intermediate reflow zone 14b, and the reflow temperature 240°C is maintained in the final reflow zone 14c, wherein the heating time for reflow is set even longer than in (b) in a melted state of solder paste.

In Fig. 3(d), the temperature rise slope from the preheating temperature 180°C is set small in the first reflow zone 14a, the temperature rise slope to the reflow temperature 240°C is set large in the intermediate reflow zone 14b, and the temperature is controlled so as to be maintained at the reflow temperature 240°C in the final reflow zone 14c, whereby the heating time for reflow is set shorter in a melted state of solder paste than in (b). This case has intermediate temperature characteristics between (a) and (b).

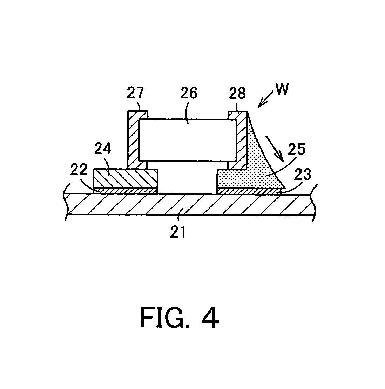

In Fig. 3 (e), the work temperature is raised at a fixed slope from the preheating temperature 180°C to the reflow temperature 240°C across all the zones including the first reflow zone 14a, intermediate reflow zone 14b and final reflow zone 14c, wherein the temperature rise slope is set at the most gradual when melting solder paste, and the reflow peak time can be shortened so as to conform to a work having a small thermal capacity and a weak heat resistance. By thus heating a work for reflow, it is possible to prevent small components as shown in Fig. 4 from being subjected to unbalanced reflow.

That is, as shown in Fig. 4, electrode portions 27 and 28 for a chip component 26 are mounted at the land portions 22 and 23 of the substrate 21 of the work W by solder paste 24 and 25. However, where the chip component 26 is radically heated for reflow, a difference in temperature occurs between the left and right electrode portions 27 and 28, wherein although solder paste 24 that is in contact with one electrode portion 27 is not in a reflow state, solder paste 25 that is in contact with the other electrode portion 28 is brought into a reflow state. Then, surface tension acts on the solder paste 25, which is in a reflow state, in the direction of the arrow, a chip standing phenomenon for a chip component 26 to be separated from the solder paste 24 and to be erected therefrom, a so called Manhattan phenomenon occurs. However, as shown in (e), by making the temperature rise slope gradual when melting solder paste, the temperature of the left and right electrode portions 27 and 28 can be raised equally, where both solder pastes 24 and 25 that are in contact therewith are caused to reflow at the same time, and it is possible to prevent defective soldering such as a chip standing phenomenon that is apt to occur in small-sized components.

Fig. 3(f) shows a case where the work temperature is controlled at the preheating temperature 180°C in the first reflow zone 14a and the intermediate reflow zone 14b, and is raised from the preheating temperature 180°C to the reflow temperature 240°C only in the final reflow zone 14c, and thereafter is immediately cooled down, wherein the reflow peak time is the shortest in amelted state of solderpaste. Therefore, this case is suitable for heating a work W, which is most deficient in heat resistance, for reflow.

In Fig. 3(g), the work temperature is raised from the preheating temperature 180°C to the reflow temperature 240°C in the first reflow zone 14a, and is controlled so as to be maintained at the reflow temperature 240°C in the intermediate zone 14b and the final reflow zone 14c. This is suitable for a case where reflow heating time necessary and sufficient to obtain a sufficient soldering connection is secured in a work W having a large thermal capacity, wherein a longer reflow peak time than the reflow peak time in the conventional (h) can be brought about.

Thus, since a plurality of reflow zones 14a, 14b and 14c, the length of which is formed shorter than the individual preheating zones 13a through 13e of the preheating area 13 in the work transfer direction, are provided in the reflow area 14, the temperature profiles such as reflow peak time of work W heated in the reflow zones 14a, 14b and 14c for reflow can be more precisely adjusted than in the conventional art. For example, components having weak heat resistance canbe processed by shortening the reflow peak time based on compact trapezoidal or triangular temperature profiles, andontheotherhand, reflow peak time necessary and sufficient to obtain a sufficient soldering connection can be secured, wherein various temperature profiles can be established.

In particular, since the three reflow zones 14a, 14b and 14c are individually controlled with respect to the temperature thereof, the temperature profile of the reflow area 14 can be more precisely adjusted than in the conventional reflow area 4 having two reflow zones 4a and 4b, wherein variation in the temperature adjustment pattern can be widened.

Further, various temperature profiles can be established without making the conventional apparatus large-sized, a work with a wide range of characteristics can be processed.

### Industrial Applicability

The present invention is applicable to a reflow apparatus suitable for reflow soldering using lead-free solder, and further may be applicable for other uses.

## Claims

1. A reflow apparatus, comprising:
a furnace body;
a work transfer conveyor for transferring a work into the furnace body;
a preheating area having a plurality of preheating zones, which is provided in the furnace body along the work transfer conveyor and preheats the work; and
a reflow area having a plurality of reflow zones for heating the work for reflow, which is provided in the furnace body along the work transfer conveyor;
wherein the lengths of individual reflow zones of the reflow area are formed shorter than the lengths of individual preheating zones of the preheating area in the work transfer direction.

2. A reflow apparatus according to Claim 1, wherein three reflow zones are provided in the reflow area; and
the temperature profile of the reflow area is settable based on respective set temperatures.
